# EUROPEAN PATENT APPLICATION

(11) **EP 4 783 770 A1**
(43) Date of publication of application: **29.07.2026**
(21) Application number: 25154549.7
(22) Date of filing: 28.01.2025
(51) Int. Cl.: H10D 64/20, H10D 64/27, H10D 30/47, H10D 62/17, H10D 62/85

(54) **HIGH ELECTRON MOBILITY TRANSISTOR (HEMT) DEVICES AND METHODS OF MANUFACTURE**

(71) Applicant: Huawei Technologies Co., Ltd., Shenzhen, Guangdong 518129 (CN)
(72) Inventor: MOUHOUBI, Samir, 80992 Munich (DE); CURATOLA, Gilberto, 80992 Munich (DE); EL-HUNI, Walid, 80992 Munich (DE)
(74) Representative: Isarpatent

(57) **Abstract**

A p-type doped gallium nitride, pGaN, High Electron Mobility Transistor, HEMT, device is described. The device comprises:
a substrate (101); a barrier layer (103) formed on the substrate; a pGaN layer (105) formed on the barrier layer, wherein the pGaN layer is etched to form a gate region for the device; a self-aligned dielectric spacer (109) formed on the barrier layer adjacent to the gate region, wherein the self-aligned dielectric spacer is formed by a self-aligned process comprising deposition and a combination of isotropic and anisotropic etching; and a self-aligned metallic spacer (111) formed on top of the self-aligned dielectric spacer, wherein the self-aligned metallic spacer is formed by a self-aligned process comprising deposition and a combination of isotropic and anisotropic etching, wherein the self-aligned metallic spacer acts as a field plate for the device.

## Description

### TECHNICAL FIELD

The present disclosure relates, in general, to High Electron Mobility Transistor (HEMT) devices. Aspects relate to metallic field plates for HEMT devices.

### BACKGROUND

A pGaN HEMT device (p-type Gallium Nitride High Electron Mobility Transistor) is a specialized type of transistor used in power electronics applications. It is an enhancement-mode (normally-off) device that incorporates a p-type doped GaN layer as the gate material. These devices offer high switching speeds, low on-resistance, and high breakdown voltages and overcome limitations of traditional GaN HEMTs, providing improved safety, reduced power consumption in the off-state, and compatibility with conventional driving circuits.

A field plate in a pGaN HEMT device is a structural element designed to manage and control the electric field distribution within the transistor. They help to redistribute the peak electric field away from critical areas of the device, such as the gate edge for example. By spreading the electric field, field plates increase the device's ability to withstand higher voltages before breakdown occurs.

In pGaN HEMT devices, field plates are typically metal structures that extend over an Aluminium Gallium Nitride (AlGaN) barrier layer, and are often connected to the gate or source.

### SUMMARY

An objective of the present disclosure is to provide a device and method of manufacturing a device that overcome lithography-based field plate formation issues by using a self-aligned based process.

The foregoing and other objectives are achieved by the features of the independent claims.

Further implementation forms are apparent from the dependent claims, the description and the Figures.

A first aspect of the present disclosure provides a p-type doped gallium nitride, pGaN, High Electron Mobility Transistor, HEMT, device, comprising a substrate, a barrier layer formed on the substrate, a pGaN layer formed on the barrier layer, wherein the pGaN layer is etched to form a gate region for the device, a self-aligned dielectric spacer formed on the barrier layer adjacent to the gate region, wherein the self-aligned dielectric spacer is formed by a self-aligned process comprising deposition and a combination of isotropic and anisotropic etching, and a self-aligned metallic spacer formed on top of the self-aligned dielectric spacer, wherein the self-aligned metallic spacer is formed by a self-aligned process comprising deposition and a combination of isotropic and anisotropic etching, and wherein the self-aligned metallic spacer acts as a field plate for the device.

Such a device is applicable to any power conversion system or architecture using semiconductor power devices, in particular wide bandgap (such as GaN-HEMT switches). A device as provided herein allows a better fabrication control of the HEMT structure geometrical features that are important for field management. This results in better device performance (field shielding) and a better fabrication technology mass production capabilities (yield, uniformity).

In an implementation of the first aspect, the pGaN HEMT device can further comprise a metallic gate feature formed on top of the etched pGaN layer. The metallic gate feature and the self-aligned metallic spacer can be electrically connected to one another. The metallic gate feature and the self-aligned metallic spacer can be electrically isolated from one another. The self-aligned metallic spacer can be electrically floating. The self-aligned metallic spacer can be electrically connected to a source potential.

In an example, the pGaN HEMT device can further comprise an additional dielectric layer between the barrier layer and the self-aligned dielectric spacer.

The metallic gate structure can be displaced from the edge of the etched pGaN layer, forming a gap that can be filled with (or otherwise filled by) a dielectric material.

The pGaN HEMT device can further comprise multiple self-aligned dielectric spacers and self-aligned metal spacers forming a stepped field plate structure for the device. The dimensions of the self-aligned dielectric spacer and the self-aligned metallic spacer can be configured to control electric field management in the device.

A second aspect of the present disclosure provides a method of manufacturing a p-type doped gallium nitride, pGaN, High Electron Mobility Transistor, HEMT, device, the method comprising forming a barrier layer on a substrate, forming and etching a pGaN layer on the barrier layer to create a gate region for the device, depositing a dielectric layer and performing a combined isotropic and anisotropic etch to form a self-aligned dielectric spacer adjacent to the etched pGaN layer, and depositing a metallic layer and performing a combined isotropic and anisotropic etch to form a self-aligned metallic spacer on top of the self-aligned dielectric spacer, wherein the self-aligned metallic spacer acts as a field plate for the device.

In an implementation of the second aspect, the method can further comprise forming a metallic gate feature on the etched pGaN layer. The method can further comprise one of: electrically connecting the self-aligned metallic spacer to the metallic gate feature, leaving it electrically floating, or connecting it to a source potential. The method can further comprise forming an additional dielectric layer between the barrier layer and the self-aligned dielectric spacer. The method can further comprise etching the metallic gate structure away from the edge of the etched pGaN layer top to form a gap, and filling the gap with a dielectric material.

These and other aspects of the invention will be apparent from the embodiment(s) described below.

### BRIEF DESCRIPTION OF THE DRAWINGS

In order that the present disclosure may be more readily understood, embodiments will now be described, by way of example, with reference to the accompanying drawings, in which:

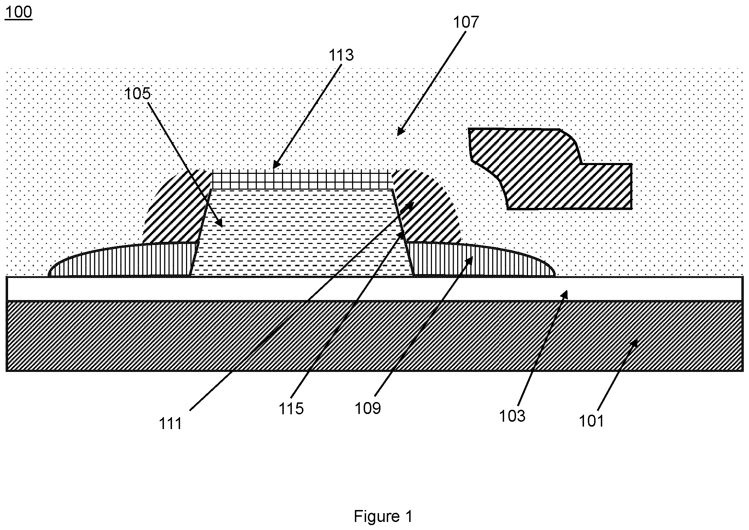

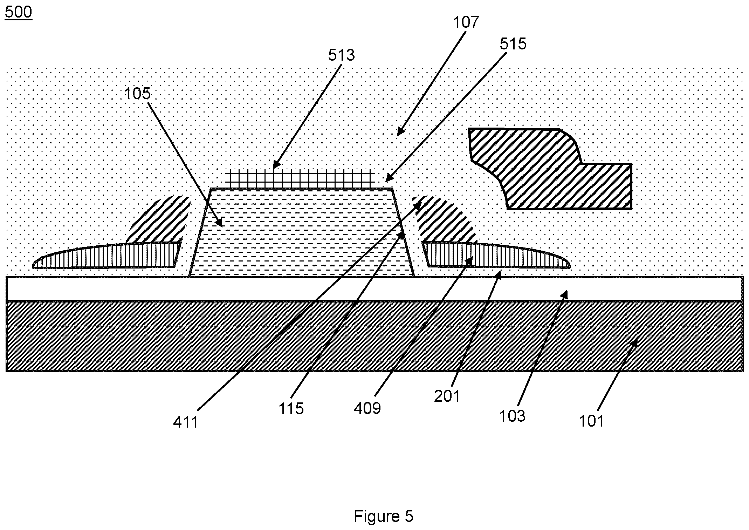

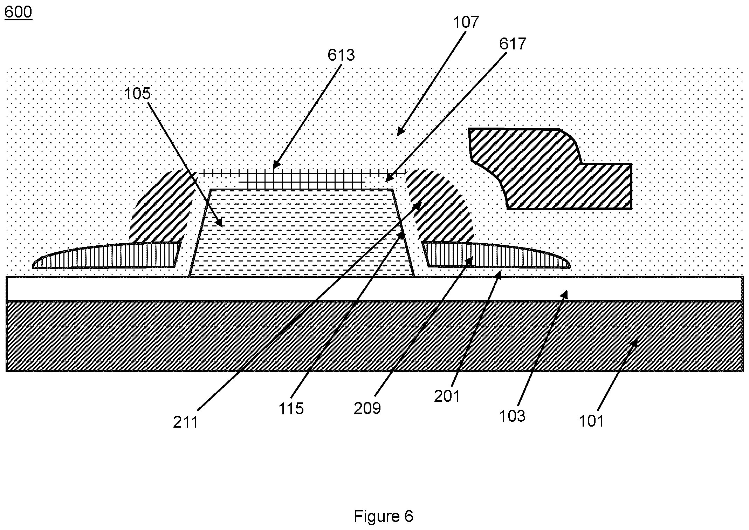

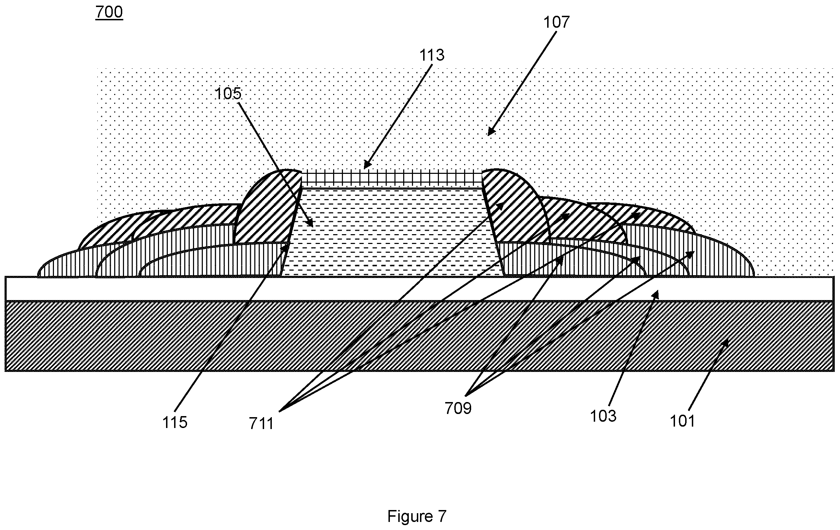

Figures 1 to 7 are schematic representations of GaN-HEMT devices, according to various examples.

### DETAILED DESCRIPTION

Example embodiments are described below in sufficient detail to enable those of ordinary skill in the art to embody and implement the systems and processes herein described. It is important to understand that embodiments can be provided in many alternate forms and should not be construed as limited to the examples set forth herein.

Accordingly, while embodiments can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

The terminology used herein to describe embodiments is not intended to limit the scope. The articles "a," "an," and "the" are singular in that they have a single referent, however the use of the singular form in the present document should not preclude the presence of more than one referent. In other words, elements referred to in the singular can number one or more, unless the context clearly indicates otherwise. It will be further understood that the terms "comprises," "comprising," "includes," and/or "including," when used herein, specify the presence of stated features, items, steps, operations, elements, and/or components, but do not preclude the presence or addition of one or more other features, items, steps, operations, elements, components, and/or groups thereof. The term "and/or" is only an association relationship for describing associated objects and represents that three relationships may exist such that A and/or B may indicate that A exists alone, A and B exist at the same time, or B exists alone. The character "/" generally represents that the associated objects are in an "or" relationship.

Unless otherwise defined, all terms (including technical and scientific terms) used herein are to be interpreted as is customary in the art. It will be further understood that terms in common usage should also be interpreted as is customary in the relevant art and not in an idealized or overly formal sense unless expressly so defined herein.

The following contains specific information related to implementations of the present disclosure. The drawings and their accompanying detailed disclosure are merely directed to implementations. However, the present disclosure is not limited to these implementations. Other variations and implementations of the present disclosure will be obvious to those skilled in the art.

The phrases "in one implementation," or "in some implementations," may each refer to one or more of the same or different implementations. The term "coupled" is defined as connected whether directly or indirectly through intervening components and is not necessarily limited to physical connections. The expression "at least one of A, B and C" or "at least one of the following: A, B and C" means "only A, or only B, or only C, or any combination of A, B and C."

The terms "system" and "network" may be used interchangeably.

For the purposes of explanation and non-limitation, specific details such as functional entities, techniques, protocols, and standards are set forth for providing an understanding of the present disclosure. In other examples, detailed disclosure of well-known methods, technologies, systems, and architectures are omitted so as not to obscure the present disclosure with unnecessary details.

Field plates in pGaN HEMT devices can be implemented in various configurations, including single or multiple field plate designs, to optimize device performance for specific applications. The effectiveness of field plates depends on factors such as their length, thickness of dielectric stack below it, and positioning relative to other device structures. Proper design and implementation of field plates are crucial for achieving high-performance pGaN HEMT devices suitable for power electronics applications.

Two main field plate concepts are widely used to manage the electrical field around the gate region of HEMTs: non-self-aligned gate metal or self-aligned gate metal. In the non-self-aligned gate metal case, gate metal is patterned after a pGaN layer etch (i.e., metal deposition, followed by a mask patterning, then finally the metal etch). A metal field plate fabricated in this way is designed to get closer to the pGaN edge and limits the electric field increase. However, in this process, the field plate is created by lithography, which is subject to strong lithography related misalignments.

In the self-aligned gate metal case, gate metal is patterned at the same time as the pGaN gate. In this case, the gate metal cannot be used as a field plate layer and an independent field plate metal needs to be added by lithography. As above, the structure is subject to lithography misalignments.

Accordingly, in both cases, the metal used as a first level of field plate is manufactured inherently by a non-self-aligned process, which generates an unavoidable misalignment issue of the field plate metal towards other elements of the HEMT. This results in a large non-uniformity of the structure performance within wafers and from wafer-to-wafer within lots.

According to an example, the present disclosure describes a HEMT device and method of manufacture that addresses the issue of field plate misalignment. Aspects relate to pGaN-HEMT devices, although the principles described herein are applicable more broadly to GaN-HEMT devices in general. The present disclosure enables the shortcomings of lithography-based field plate formation, as described above for example, to be overcome using a self-aligned based process.

In an example, self-alignment is achieved by the formation of two (or more) spacers at the sides of etched pGaN. For example, a dielectric spacer can be formed at the pGaN edge by deposition and a combination of an isotropic and an anisotropic etch of a dielectric layer. A metal spacer can be formed by deposition and an anisotropic etch of a metal layer.

In this manner, the spacer concept is a self-aligned method, which yields no misalignments. As such , electrical field management is controlled by the dimensions of the spacers, and field plate efficiency is controlled by the thickness of the dielectric spacer. Field plate extension is controlled by the length of the metal spacer.

Figure 1 is a schematic representation of GaN-HEMT device, according to an example. The example of figure 1 can comprise, e.g., a p-type doped gallium nitride, pGaN, HEMT. The device 100 comprises a substrate 101, and a barrier layer 103 formed on the substrate 101. A pGaN layer 105 is formed on the barrier layer 103. The pGaN layer 105 can be etched as depicted in figure 1 to form a gate region 107 for the device 100.

A self-aligned dielectric spacer 109 is formed on the barrier layer 103 adjacent to the gate region 107. The self-aligned dielectric spacer 109 is, in an example, formed by a self-aligned process comprising deposition and a combination of isotropic and anisotropic etching.

A self-aligned metallic spacer 111 is formed on top of the self-aligned dielectric spacer 109. The self-aligned metallic spacer 111 is, in an example, formed by a self-aligned process comprising deposition and a combination of isotropic and anisotropic etching. The self-aligned metallic spacer 111 acts as a field plate for the device 100.

Accordingly, in the example of figure 1, the dielectric spacer 109 is formed on top of the barrier layer 103, which can comprise a layer of AlGaN for example. The metal spacer 111 is formed on top of the dielectric spacer 109, and the metal spacer 111 is connected to the main gate metal 113. In an example, the metal spacer 111 and the main gate metal 113 are the same material and may be deposited at the same time rather than separately for example.

Thus, the metal spacer 111 is electrically connected to the main gate metal 113 and is in contact with the pGaN 105 sidewalls 115, which allows a uniform voltage to be applied to the pGaN surface and pGaN sidewall. In an example, the field plate can be as close as possible to the 2D electron gas independently from any second field plate.

In the context of the present disclosure, self-alignment refers to a manufacturing technique where certain device features are automatically positioned relative to each other without the need for separate lithography steps. This improves accuracy and reduces alignment errors that can occur during traditional lithography-based methods. As such, misalignment of the field plate or plates (e.g., 111 as shown in figure 1) is avoided.

According to an example, self-alignment used for formation of features of a GaN-HEMT device enables precise positioning of device components, often at the nanometer scale, such as field plates, and minimizes variations between devices on the same wafer and between different wafers. This results in better device performance due to more consistent and precise structures and, since the number of lithography steps is reduced, self-alignment can lower manufacturing costs, whilst being useful as device dimensions shrink.

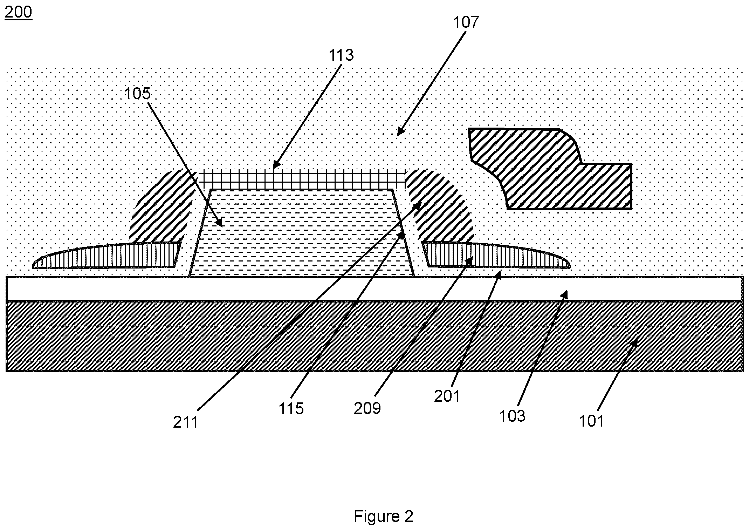

Figure 2 is a schematic representation of GaN-HEMT device, according to an example. The example of figure 2 can comprise, e.g., a p-type doped gallium nitride, pGaN, HEMT. The device 200 comprises a substrate 101, and a barrier layer 103 formed on the substrate 101. A pGaN layer 105 is formed on the barrier layer 103. The pGaN layer 105 can be etched as depicted in figure 2 to form a gate region 107 for the device 200.

In contrast to the example described above with reference to figure 1, a self-aligned dielectric spacer 209 is formed on a (or more than one) dielectric layer 201 that has been deposited on the barrier layer 103 adjacent to the gate region 107 and which extends up the sidewalls 115 of the pGaN 105. The self-aligned dielectric spacer 209 is, in an example, formed by a self-aligned process comprising deposition and a combination of isotropic and anisotropic etching.

A self-aligned metallic spacer 211 is formed on top of the self-aligned dielectric spacer 209. Again, the self-aligned metallic spacer 211 is formed on a (or more than one) dielectric layer 201 that has been deposited adjacent to the gate region 107.

The self-aligned metallic spacer 211 is, in an example, formed by a self-aligned process comprising deposition and a combination of isotropic and anisotropic etching. The self-aligned metallic spacer 211 acts as a field plate for the device 200.

Accordingly, in the example of figure 2, the dielectric spacer 209 is formed on top of one or more dielectric layers 201 that are deposited on the barrier layer 103, which can comprise a layer of AlGaN for example. The metal spacer 211 is formed on top of the dielectric spacer 209, but as the pre-deposited one or more dielectric layers 201 extend up the sidewalls 115 of the pGaN 105, the metal spacer 211 is provided in spaced relation to the pGaN 105. Similarly, the dielectric spacer 209 is provided in spaced relation to the to the pGaN 105 and the barrier layer 103.

The metal spacer 211 is connected to the main gate metal 113. In an example, the metal spacer 211 and the main gate metal 113 are the same material and may be deposited at the same time rather than separately for example.

Thus, the metal spacer 211 is electrically connected to the main gate metal 113 but is not in contact with the pGaN 105 sidewalls 115, which permits hole injection limitation. As before, the field plate can be as close as possible to the 2D electron gas independently from a second field plate. The dielectric layer (or layers) 201 can be deposited using atomic layer deposition, which can be beneficial for the integrity of the AlGaN interface (buffer layer 103).

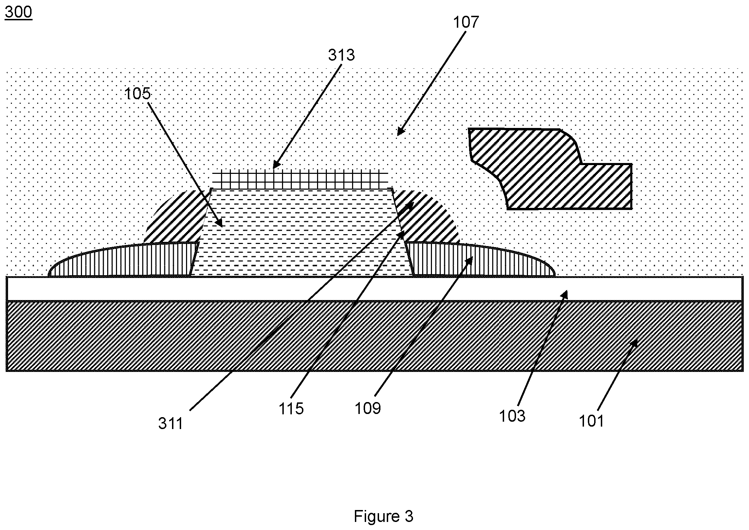

Figure 3 is a schematic representation of GaN-HEMT device, according to an example. The example of figure 3 can comprise, e.g., a p-type doped gallium nitride, pGaN, HEMT. The device 300 comprises a substrate 101, and a barrier layer 103 formed on the substrate 101. A pGaN layer 105 is formed on the barrier layer 103. The pGaN layer 105 can be etched as depicted in figure 3 to form a gate region 107 for the device 300.

A self-aligned dielectric spacer 109 is formed on the barrier layer 103 adjacent to the gate region 107. The self-aligned dielectric spacer 109 is, in an example, formed by a self-aligned process comprising deposition and a combination of isotropic and anisotropic etching.

A self-aligned metallic spacer 311 is formed on top of the self-aligned dielectric spacer 109. In the example of figure 3, the metal spacer 311 is disconnected from the main gate metal 313 and left electrically floating.

The self-aligned metallic spacer 311 is, in an example, formed by a self-aligned process comprising deposition and a combination of isotropic and anisotropic etching. The self-aligned metallic spacer 311 acts as a field plate for the device 300.

Accordingly, in the example of figure 3, as the metallic spacer 311 is electrically floating, its potential will be set by coupling to the pGaN 105 potential and any field plates in its vicinity, thereby providing less field plate effect but smoother transition of potential (relaxed E-field). The metallic spacer 311 is in contact with the pGaN 105 sidewalls 115, therefore allowing a uniform voltage to be applied to the pGaN sidewalls. As before, the field plate can be as close as possible to the 2D electron gas independently from a second field plate.

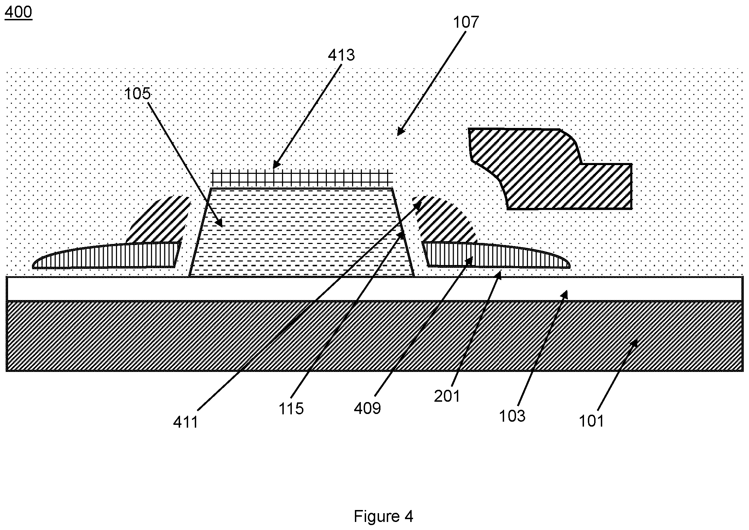

Figure 4 is a schematic representation of GaN-HEMT device, according to an example. The example of figure 4 can comprise, e.g., a p-type doped gallium nitride, pGaN, HEMT. The device 400 comprises a substrate 101, and a barrier layer 103 formed on the substrate 101. A pGaN layer 105 is formed on the barrier layer 103. The pGaN layer 105 can be etched as depicted in figure 4 to form a gate region 107 for the device 400.

In contrast to the example described above with reference to figure 1, a self-aligned dielectric spacer 409 is formed on a (or more than one) dielectric layer 201 that has been deposited on the barrier layer 103 adjacent to the gate region 107 and which extends up the sidewalls 115 of the pGaN 105. The self-aligned dielectric spacer 409 is, in an example, formed by a self-aligned process comprising deposition and a combination of isotropic and anisotropic etching.

A self-aligned metallic spacer 411 is formed on top of the self-aligned dielectric spacer 409. Again, the self-aligned metallic spacer 411 is formed on a (or more than one) dielectric layer 201 that has been deposited adjacent to the gate region 107.

The self-aligned metallic spacer 411 is, in an example, formed by a self-aligned process comprising deposition and a combination of isotropic and anisotropic etching. The self-aligned metallic spacer 411 acts as a field plate for the device 400.

Accordingly, in the example of figure 4, the dielectric spacer 409 is formed on top of one or more dielectric layers 201 that are deposited on the barrier layer 103, which can comprise a layer of AlGaN for example. The metal spacer 411 is formed on top of the dielectric spacer 409, but as the pre-deposited one or more dielectric layers 201 extend up the sidewalls 115 of the pGaN 105, the metal spacer 411 is provided in spaced relation to the pGaN 105. Similarly, the dielectric spacer 409 is provided in spaced relation to the to the pGaN 105 and the barrier layer 103.

The metal spacer 411 is not connected to the main gate metal 413. That is, the metallic spacer 411 is disconnected from the main gate metal 413 and left electrically floating. In an example, the metal spacer 411 and the main gate metal 413 are the same material and may be deposited at the same time rather than separately for example.

Thus, as the metallic spacer 411 is electrically floating, its potential will be set by coupling to the pGaN 105 potential and any field plates in its vicinity, thereby providing less field plate effect but smoother transition of potential (relaxed E-field). Furthermore, the metallic spacer 411 is not in contact with the pGaN 105 sidewalls 115, which permits hole injection limitation. As before, the field plate can be as close as possible to the 2D electron gas independently from a second field plate. The dielectric layer (or layers) 201 can be deposited using atomic layer deposition, which can be beneficial for the integrity of the AlGaN interface (buffer layer 103).

Similarly to the example described with reference to figure 4, an alternative pGaN-HEMT device can be provided in which the metallic spacer 411 is disconnected from the main gate metal 413 but is connected to a source potential in the third dimension. This has the advantage of reducing gate-to-drain capacitance (i.e., the capacitance between the gate and drain terminals of the device), which can otherwise affect the device's switching speed and power efficiency. Gate-to-drain capacitance is also associated with the so-called Miller effect, which can lead to increased input capacitance during switching.

In another example, which is applicable to all of the implementations described above with reference to figure 1 to 4, the main gate metal (113; 313; 413) can be retracted or otherwise displaced from the edge of the pGaN 105. Subsequent metal depositions can connect the main gate metal to the metallic pacer (or keep both separated). As the main metal of the gate is retracted from the pGaN edge, reduced sidewall leakage is provided.

Figure 5 is a schematic representation of GaN-HEMT device, according to such an example. The example of figure 5 shows the device of figure 4, but in which the main gate metal 513 is displaced away from the edges 515 of the pGaN 105.

Figure 6 is a schematic representation of GaN-HEMT device, according to an example. The example of figure 6 shows the device of figure 2, but in which the main gate metal 613 is displaced away from the edges 115 of the pGaN 105 by a dielectric filler 617.

Figure 7 is a schematic representation of GaN-HEMT device, according to an example. In the example of figure 7, device 700 comprises multiple dielectric spacers 709 and multiple metallic spacers 711 are created to create a stepped field plate, which can offer improved field management. The stepped field plate device can be connected to the main gate metal, to a source, or left floating, as described above with respect to any of the other examples.

Any example described above with reference to any of figures 1 to 7 may be combined with any other example described above.

According to an example, self-aligned spacer field plate formation (instead of, e.g., lithography-patterning process), eliminates the misalignments induced by the lithography process. The electric field can be controlled by the dimensions of the spacers, therefore limiting the presence of the dielectric to the vicinity of the metal field plate. It is possible to independently electrically bias the spacer field plate to the Gate, Source or leave it floating, resulting in a higher level of tunability of the electric field for a device. It is possible to physically and electrically connect the spacer field plate to the pGaN Gate, thereby enabling modulation of the hole injection process. A multi field plate structure can be provided, which enables better field management.

While various embodiments have been described and/or illustrated herein in the context of fully functional computing systems, one or more of these exemplary embodiments may be distributed as a program product in a variety of forms, regardless of the particular type of computer-readable-storage media used to actually carry out the distribution. The embodiments disclosed herein may also be implemented using software modules that perform certain tasks. These software modules may include script, batch, or other executable files that may be stored on a computer-readable storage medium or in a computing system. In some embodiments, these software modules may configure a computing system to perform one or more of the exemplary embodiments disclosed herein. In addition, one or more of the modules described herein may transform data, physical devices, and/or representations of physical devices from one form to another.

The preceding description has been provided to enable others skilled in the art to best utilize various aspects of the exemplary embodiments disclosed herein. This exemplary description is not intended to be exhaustive or to be limited to any precise form disclosed. Many modifications and variations are possible without departing from the spirit and scope of the instant disclosure. The embodiments disclosed herein should be considered in all respects illustrative and not restrictive. Reference should be made to the appended claims and their equivalents in determining the scope of the instant disclosure.

## Claims

1. A p-type doped gallium nitride, pGaN, High Electron Mobility Transistor, HEMT, device, comprising:
a substrate;
a barrier layer formed on the substrate;
a pGaN layer formed on the barrier layer, wherein the pGaN layer is etched to form a gate region for the device;
a self-aligned dielectric spacer formed on the barrier layer adjacent to the gate region, wherein the self-aligned dielectric spacer is formed by a self-aligned process comprising deposition and a combination of isotropic and anisotropic etching; and
a self-aligned metallic spacer formed on top of the self-aligned dielectric spacer, wherein the self-aligned metallic spacer is formed by a self-aligned process comprising deposition and a combination of isotropic and anisotropic etching, and wherein
the self-aligned metallic spacer acts as a field plate for the device.

2. The pGaN HEMT device of claim 1, further comprising a metallic gate feature formed on top of the etched pGaN layer.

3. The pGaN HEMT device of claim 2, wherein the metallic gate feature and the self-aligned metallic spacer are electrically connected to one another.

4. The pGaN HEMT device of claim 2, wherein the metallic gate feature and the self-aligned metallic spacer are electrically isolated from one another.

5. The pGaN HEMT device of any preceding claim, wherein the self-aligned metallic spacer is electrically floating.

6. The pGaN HEMT device of any of claims 1 to 4, wherein the self-aligned metallic spacer is electrically connected to a source potential.

7. The pGaN HEMT device of any preceding claim, further comprising an additional dielectric layer between the barrier layer and the self-aligned dielectric spacer.

8. The pGaN HEMT device of claim 2, wherein the metallic gate structure is dispalced from the edge of the etched pGaN layer, forming a gap that is filled with a dielectric material.

9. The pGaN HEMT device of any preceding claim, further comprising multiple self-aligned dielectric spacers and self-aligned metal spacers forming a stepped field plate structure for the device.

10. The pGaN HEMT device of any preceding claim, wherein the dimensions of the self-aligned dielectric spacer and the self-aligned metallic spacer are configured to control electric field management in the device.

11. A method of manufacturing a p-type doped gallium nitride, pGaN, High Electron Mobility Transistor, HEMT, device, the method comprising:
forming a barrier layer on a substrate;
forming and etching a pGaN layer on the barrier layer to create a gate region for the device;
depositing a dielectric layer and performing a combined isotropic and anisotropic etch to form a self-aligned dielectric spacer adjacent to the etched pGaN layer; and
depositing a metallic layer and performing a combined isotropic and anisotropic etch to form a self-aligned metallic spacer on top of the self-aligned dielectric spacer, wherein the self-aligned metallic spacer acts as a field plate for the device.

12. The method of claim 11, further comprising:
forming a metallic gate feature on the etched pGaN layer.

13. The method of claim 12, further comprising:
one of: electrically connecting the self-aligned metallic spacer to the metallic gate feature, leaving it electrically floating, or connecting it to a source potential.

14. The method of any of claims 11 to 13, further comprising:
forming an additional dielectric layer between the barrier layer and the self-aligned dielectric spacer.

15. The method of any of claims 11 to 12, further comprising:
etching the metallic gate structure away from the edge of the etched pGaN layer top to form a gap; and
filling the gap with a dielectric material.

## Amended claims

### Amended claims in accordance with Rule 137(2) EPC.

1. A method of manufacturing a p-type doped gallium nitride, pGaN, High Electron Mobility Transistor, HEMT, device, the method comprising:
forming a barrier layer (103) on a substrate (101);
forming and etching a pGaN layer (105) on the barrier layer (103) to create a gate region (107) for the device;
depositing a dielectric layer and performing a combined isotropic and anisotropic etch of the dielectric layer to form a self-aligned dielectric spacer (109) adjacent to the etched pGaN layer (105); and
depositing a metallic layer and performing a combined isotropic and anisotropic etch of the metallic layer to form a self-aligned metallic spacer (111) on top of the self-aligned dielectric spacer (109), wherein the self-aligned metallic spacer (111) acts as a field plate for the device.

2. The method of claim 1, further comprising:
forming a metallic gate (113) feature on the etched pGaN layer (105).

3. The method of claim 2, further comprising:
one of: electrically connecting the self-aligned metallic spacer (111) to the metallic gate feature (113), leaving it electrically floating, or connecting it to a source potential.

4. The method of any of claims 1 to 3, further comprising:
forming an additional dielectric layer (201) between the barrier layer (103) and the self-aligned dielectric spacer (109).

5. The method of claim2, further comprising:
etching the metallic gate feature (113) away from the edge of the etched pGaN layer (105) top to form a gap; and
filling the gap with a dielectric material (617).
